(19) **Europäisches Patentamt** / **European Patent Office** / **Office européen des brevets**

(11) **EP 3 389 077 B1**

(12) **EUROPEAN PATENT SPECIFICATION**

(45) Date of publication and mention
of the grant of the patent:
**29.01.2020 Bulletin 2020/05**

(21) Application number: **17171637.6**

(22) Date of filing: **18.05.2017**

(51) Int Cl.:
*H01H 85/046* (2006.01)    *H01H 85/38* (2006.01)
*H01H 85/10* (2006.01)    *H01H 69/02* (2006.01)
*H05K 1/02* (2006.01)    *H01H 85/02* (2006.01)

(54) **PRINTED CIRCUIT FUSE AND METHOD FOR USE OF THE SAME**

LEITERPLATTENSICHERUNG UND VERFAHREN ZUR VERWENDUNG DAVON

FUSIBLE DE CIRCUIT IMPRIMÉ ET SON PROCÉDÉ D'UTILISATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **10.04.2017 EP 17461519**

(43) Date of publication of application:
**17.10.2018 Bulletin 2018/42**

(73) Proprietor: **Fibar Group S.A.
60-421 Poznan (PL)**

(72) Inventor: **Zdunek, Robert
60-415 Pozna (PL)**

(74) Representative: **Blonski, Pawel
EP-Patent
Konstruktorow 30/2
65-119 Zielona Gora (PL)**

(56) References cited:
**JP-A- 2007 018 774     US-A1- 2010 142 110
US-A1- 2011 241 817**

**Description**

**TECHNICAL FIELD**

The present invention relates to a printed circuit fuse and method for use of the same. In particular, the present invention relates to a high breaking capacity printed circuit fuse for use in a multi-layer printed circuit board.

**BACKGROUND OF THE INVENTION**

In electronics and electrical engineering, a fuse is a type of low resistance resistor that acts as a sacrificial device to provide overcurrent protection, of either the load or source circuit. Its essential component is a metal wire or a strip that melts when excessive current flows through it, interrupting the circuit that it connects. Short circuits, overloading, mismatched loads, or device failure are the typical reasons for excessive current. Fuses can be used as alternatives to electrical circuit breakers.

A fuse interrupts an excessive current so that further damage by overheating or fire is prevented. Wiring regulations often define a maximum fuse current rating for particular circuits. Overcurrent protection devices are essential in electrical systems in order to limit threats to human life and property damage (source: Wikipedia).

Further, breaking capacity or interrupting rating is a current that a particular fuse, circuit breaker, or other electrical apparatus is able to interrupt without being destroyed or causing an electric arc with unacceptable duration. The prospective short circuit current, which can occur under short circuit conditions should not exceed the rated breaking capacity of the apparatus. Otherwise, breaking of the current cannot be guaranteed. Breaking capacity current corresponds to a voltage, therefore an electrical apparatus may have more than one breaking capacity current, according to the voltage (source: Wikipedia).

High voltage applications require a fuse element that can handle the energy and electrical arcing associated with an opening of the element of the fuse or electrical circuit.

In the current era of small-sized electronic devices and common use of printed circuit boards, efficient high breaking capacity fuses are required to fit into printed circuit boards design.

An example of a fuse for a circuit board is present in EP1045625 (A1), entitled "A foil fuse made on a circuit board" that discloses a foil fuse made on a circuit board, which fuse consists of a narrowed part (3) of a foil conductor (2) on the surface of the circuit board (1), and of a protective capsule (6, 7) covering the said part. To guide the hot gases and any splashes of molten material produced when a fuse blows to the safe side of the circuit board, there is a gap (4) in the circuit board (1), which is covered by the protective capsule (6, 7) and located adjacent to the foil fuse (3).

Another example US 20120013431 A1 entitled "Fuse element", discloses a fuse element (10), in particular suited for use in electric and/or electronic circuits constructed by multi-layer technology, including a printed circuit board substrate material (11), which is usable particularly in the multi-layer technology and is coated with a metal or metal alloy (15), from which metal or metal alloy the fuse (12) is generated by means of photolithographic and/or printing image-producing techniques and ensuing etching or engraving processes, is proposed. The fuse (10) is distinguished in that the printed circuit board substrate material (11), on which the fuse (12) can be provided, includes at least a high-temperature-stable, electrically insulating material, with a coefficient of thermal expansion that varies essentially analogously to the coefficient of thermal expansion of the metal or metal alloy (15) from which the fuse (12) is made.

The aim of the aforementioned fuse is to be formed integrally in the metal or metal alloy that is applied to a conventional printed circuit board substrate or a multi-layer printed circuit board substrate, which is suitable for stably withstanding high operating temperatures even above 200° C.

JP2007018774 (A) discloses a small chip type fuse element allowing formation of a fuse element having a sufficient length without expanding a chip size and excelling in fusing performance. A series of (for instance, spiral) fuse elements are formed by stacking a plurality of boards on one another, by forming fuse element patterns on two or more layers of the boards, and by connecting the fuse element patterns to one another. The fuse element patterns are connected to one another through, for instance, conductive materials filled in via holes formed on the boards. It is preferable that cavities are formed at least in a part of the boards to be stacked

In contrast, the aim of the present invention is a high breaking capacity fuse in a multi-layer printed circuit board, wherein the breaking capacity would be in a range of 1500A at 240VAC.

Another aim of the present invention is a method for extinguishing (or quenching) an electric arc in order to provide a high breaking capacity in a multi-layer printed circuit board.

Such fuse and method of its use are applicable in electronic devices, where by design there is a very limited space for application of a high breaking capacity fuse.

**SUMMARY AND OBJECTS OF THE PRESENT INVENTION**

An object of the present invention is a high breaking capacity printed circuit fuse as defined in the appended claims.

A further object of the present invention is a method for quenching an electric arc, the method being characterized in that it comprises the steps of: providing a multi-layer printed circuit board comprising a high breaking capacity fuse according to the present invention; and applying a breaking current to the high breaking capacity fuse.

## BRIEF DESCRIPTION OF THE DRAWINGS

These and other objects of the invention presented herein, are accomplished by providing a printed circuit fuse and method for use of the same. Further details and features of the present invention, its nature and various advantages will become more apparent from the following detailed description of the preferred embodiments shown in a drawing, in which:

Fig. 1 presents a side cross-section of a printed circuit board comprising a high breaking capacity fuse according to the present invention;

Fig. 2 depicts a top view of a printed circuit board comprising a high breaking capacity fuse according to the present invention;

Fig. 3 shows parameters of thinning of a conductive path according to the present invention;

Fig. 4 depicts a graph of energy that will be carried by a circuit when it breaks at a current of 1500A;

Fig. 5 presents a side cross-section of a printed circuit board comprising a high breaking capacity fuse during a breaking scenario; and

Fig. 6 shows a method according to the present invention.

## DESCRIPTION OF EMBODIMENTS

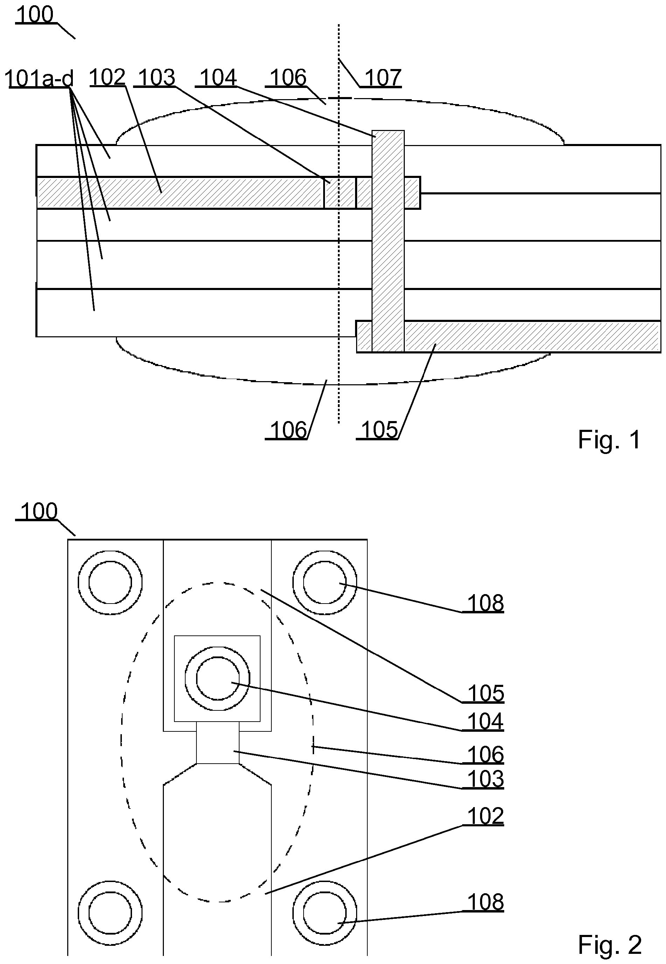

Fig. 1 presents a multi-layer printed circuit board (100) comprising a high breaking capacity fuse according to the present invention. A side view, cross-section has been presented, wherein the multi-layer printed circuit board (100) comprises at least three layers (101a-d). Namely, the layers are a top layer (101a), a middle layer (101b) and a bottom layer (101d). However, typically the number of layers will be an even number e.g. 4, 6 etc.

In this specification, the term layer refers to a laminate layer of the printed circuit board (100). Each laminate layer may include a core layer of material with a trace layer bonded to either or both of its opposite surfaces. Each trace layer may comprise one or more signal traces (conductive paths).

Alternatively, the top layer (101a) may be called a first external layer present at a first side of any middle layer (101b), while the bottom layer (101d) may be called a second external layer present opposite the first external layer (101a) with respect to the middle layer (101b).

It is to be noted, that there may be any number of intermediate, internal layers (101c) between said middle layer (101b) and the bottom layer (101d) while the top layer (101a) and the middle layer (101b) will typically be adjacent layers.

Similarly, there may be present any number of layers above (adhering to its external surface) the top layer (101a) and below (adhering to its external surface) the bottom layer (101d).

In the multi-layer circuit present on the multi-layer printed circuit board (100), there is present a conductive path or trace (102, 103, 104, 105), which passes between said layers (101a-d). The conductive path (102, 103, 104, 105) is preferably made from a conductive foil such as a copper foil, typically having a 35 micrometers thickness. Other thickness values are possible such as frequently used 18 micrometers, 70 micrometers or 105 micrometers. A designer of a circuit selects a required thickness depending on product requirements.

A first end (102) of the conductive path (102, 103, 104, 105) is located on the outer (facing either the top layer (101a) or the bottom layer (101d)) side of the middle layer (101b) of the multi-layer printed circuit board (100).

The conductive path (102, 103, 104, 105) comprises a thinning (103), at the level of the first end (102) of the conductive path (102, 103, 104, 105), which acts as a fusible link (a fuse element). The fusible link is typically made of a conductive material such as zinc, copper, silver, aluminum or alloys to provide stable and predictable characteristics.

The fuse would ideally carry its rated current indefinitely, and melt quickly on a small excess. The fuse element must not be damaged by minor harmless surges of current, and must not oxidize or change its behavior after possibly years of service.

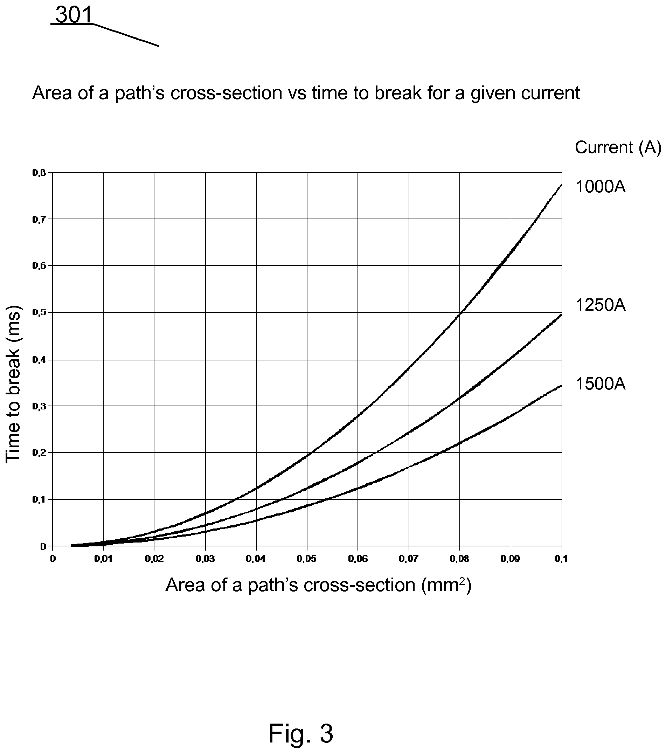

More information on the aforementioned thinning (103) will be provided with reference to Figure 3.

Next, the conductive path (102, 103, 104, 105) passes, from said thinning (103) via all respective layers (101a-d), to the bottom side of the bottom layer (101d) of the multi-layer printed circuit board (100) via at least one PCB via (104). A via or VIA (Latin for path or way, also known as vertical interconnect access) is an electrical connection between layers in a physical electronic circuit that goes through the plane of one or more adjacent layers. As shown in Fig. 1, the via passes all layers of the multi-layer printed circuit board (100) and has its outlets at external sides of the top layer (101a) and the bottom layer (101d) respectively.

The via (104) has its first end preferably as close as possible (in proximity to in general) to said thinning (103) and is connected to the other end (105), of the conductive path (102, 103, 104, 105), located on the bottom side of the bottom layer (101d) of the multi-layer printed circuit board (100).

Alternatively, the arrangement of the conductive path (102, 103, 104, 105) may be mirrored such that the first end (102) is above the other end (105) i.e. mirrored with respect to an axis crossing the length of the middle layer (101b).

The circuit, i.e. the conductive path (102, 103, 104, 105), is partially covered, on both external sides of the multi-layer printed circuit board (100), with a non-flammable agent such as a non-flammable silicone (106).

The purpose of the silicone is to quench an electric arc, thus the non-flammable agent (106) needs to have properties allowing for electric arc quenching. In particular, outlets of said via (104) are covered with the non-flammable silicone (106). The heat, caused by breaking a circuit, shall melt the non-flammable agent (106) and the melted non-flammable agent (106) subsequently floods the location of the electric arc thereby quenching the electric arc. The melting point is preferably above 100 degrees Celsius, nevertheless specific values may depend on project requirements.

In case, it is known a priori that a particular side of the multi-layer printed circuit board (100) will be a top layer (101a), the non-flammable agent (106) may be present only on that top layer, while being optional on the bottom layer (101d). Presence of the non-flammable agent (106) on both sides of the multi-layer printed circuit board (100), will increase reliability due to preventing excessive propagation of an electric arc. In other words, at least one outlet of said via (104) must be covered with the non-flammable agent (106).

Additionally, breaking tests have been carried out with respect to different orientations of the multi-layer printed circuit board (100) comprising a high breaking capacity fuse according to the present invention. There have not been noticed any effects of said orientations, of the multi-layer printed circuit board (100), on the results of breaking and electric arc quenching.

The area, covered by said silicone (106), on the top side of the top layer (101a) and on the bottom side of the bottom layer (101d) has preferably a perimeter shape similar to an ellipse or a circle but other shapes are possible. A center of said circle or ellipse being positioned in proximity or at the center (axis 107) of the thinning (103). Further, the silicone (106) may have a shape similar to a dome (as shown in Figures 1 and 2).

An example of the non-flammable agent (106) is DOW CORNING® 7094 FLOWABLE SEALANT or the like. This is a one-component, flowable neutral cure silicone adhesive/sealant. Other examples are DOW CORNING® 1-2620 LOW VOC CONFORMAL COATING or SYLGARD® 184 SILICONE ELASTOMER KIT.

In an exemplary embodiment, the amount of the non-flammable agent (106) is at lest equal to the volume of said via (104). Clearly, an excess of the non-flammable agent (106) may be provided depending on the spatial arrangements on the multi-layer printed circuit board (100).

Although, the aforementioned shapes of the non-flammable silicone (106) are preferred, other shapes may be applied such as a cuboid or a cone.

Additionally, the complete stack of the multi-layer printed circuit board (100) may be reinforced with reinforcing members such as soldered elements (108) as shown in Fig. 2. There are at least two soldered elements (108), in proximity to the non-flammable agent (106), positioned in mounting holes of the multi-layer printed circuit board (100). Alternatively, other reinforcing members may be applied such as suitable screws and nuts or similar elements preventing delamination of the layers (101a-d).

Fig. 2 depicts a top view of the multi-layer printed circuit board (100) comprising a high breaking capacity fuse according to the present invention. This view shows all elements of the conductive path (102, 103, 104, 105) present on different layers (101a-d) of the multi-layer printed circuit board (100).

It can be readily seen that the thinning (103) is present on the trace of the conductive path (102, 103, 104, 105). Further, in this embodiment there are four soldered elements (108), in proximity to the non-flammable silicone (106), positioned in mounting holes of the multi-layer printed circuit board (100). A center of said non-flammable silicone's (106) circle or ellipse being positioned in proximity to or at the center (107) of the aforementioned thinning (103).

The four soldered elements (108) constitute a strong reinforcement of the multi-layer printed circuit board (100) laminate.

Typically, the multi-layer printed circuit board (100) laminate is FR4 or FR5. FR-4 or FR4 is a grade designation assigned to glass-reinforced epoxy laminate sheets, tubes, rods and printed circuit boards. FR-4 is a composite material composed of woven fiberglass cloth with an epoxy resin binder that is flame resistant (self-extinguishing).

"FR" stands for flame retardant, and denotes that safety of flammability of FR-4 is in compliance with the standard UL94V-0.

According to the present invention, the element accepting a shock wave is the FR4 laminate, because the location, i.e. the thinning (103), where the conductive path (102, 103, 104, 105) is broken is positioned on an inner, middle layer (101b). Further, the reinforced (108) mounting holes (or otherwise Through-hole technology (THT) "thru-holes") prevent the multi-layer printed circuit board (100) from delamination.

Fig. 3 shows parameters of the thinning (103) of a conductive path (102, 103, 104, 105) according to the present invention. In particular, the graph shows selection of the width of the thinning (103) depending on the required circuit braking time at a given current. In this example three currents have been depicted, namely a current of 1000A, 1250A and 1500A has been selected.

In order to determine particular values on the graph (301), trace fusing currents have been calculated using Onderdonk's equation:

$$33\left(\frac{I}{A}\right)^2 S = \log_{10}\left(\frac{t}{234+Ta}+1\right)$$

where:

    I = the current in Ampers
    A = the cross-sectional area in circular millimeters
    S = the time in seconds the current is applied
    t = the rise in temperature from the ambient or initial state
    Ta = the reference temperature in degrees C

In this example, a typical conductive path (102, 103, 104, 105) is used, made from a copper foil having a 35 micrometers thickness. For example, as can be seen from the graph, at 35 micrometers thickness in order to obtain approx. 0,09 ms breaking time at 1500A, the thinning (103) shall have an area of 0,05 mm$^2$ of its cross-section.

Due to conductive path (102, 103, 104, 105) manufacturing process, typically in one PCB project all conductive paths have initially the same thickness and width. After that, any given conductive path may be thinned by appropriately cutting or etching.

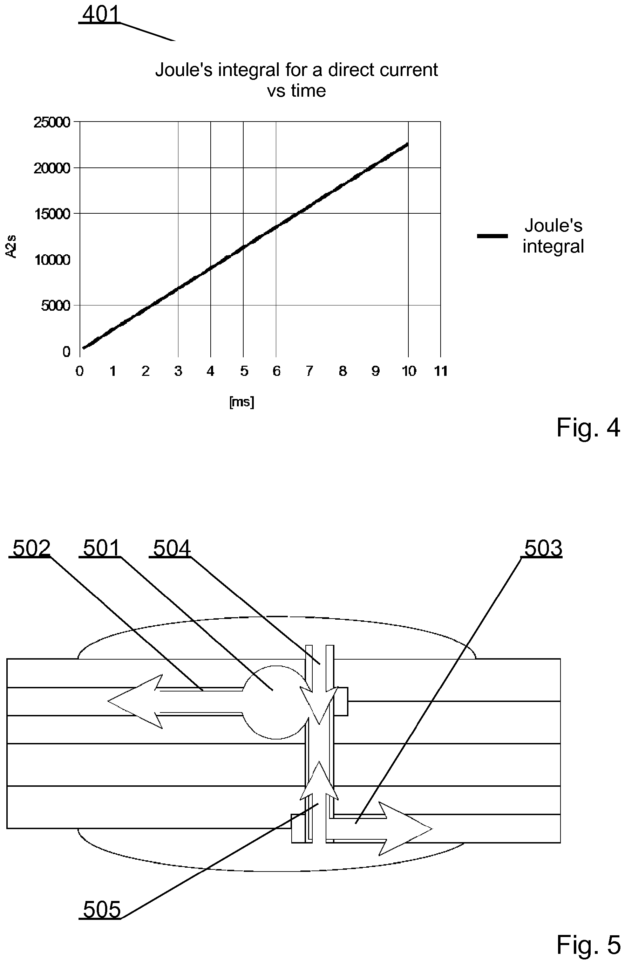

Fig. 4 depicts a graph of energy that will be carried by a circuit when it breaks at a current of 1500A. In particular, the graph depicts Joule's integral for a direct current vs time. Nominal melting is a measure of the energy required to melt the fuse element and is expressed as "Ampere Squared Seconds" (A2 Sec.). This nominal melting is not only a constant value for each fuse element design, but it is also independent of temperature and voltage.

1500A is a minimum required breaking capacity of the fuse according to the present invention.

Fig. 5 presents a side cross-section of a printed circuit board (100) comprising a high breaking capacity fuse during a breaking scenario. A current breaking the fuse element, i.e. the thinning (103), heats the path at the thinning (103) causing the conductive material, such as copper, to evaporate (501). After evaporation, the conductive path (102, 103, 104, 105) is broken and an electric arc is generated, which propagates (502, 503) along the remaining sections (102, 104, 105) of the conductive path path (102, 103, 104, 105). This further causes temperature increase, especially in the via (104). The heat melts the non-flammable agent (106) and the melted non-flammable agent (106) floods (504, 505) over the location of the electric arc thereby quenching the electric arc.

The current flow is interrupted while the reinforcing members, such as the soldered elements (108), prevent the multi-layer printed circuit board (100) from delaminating.

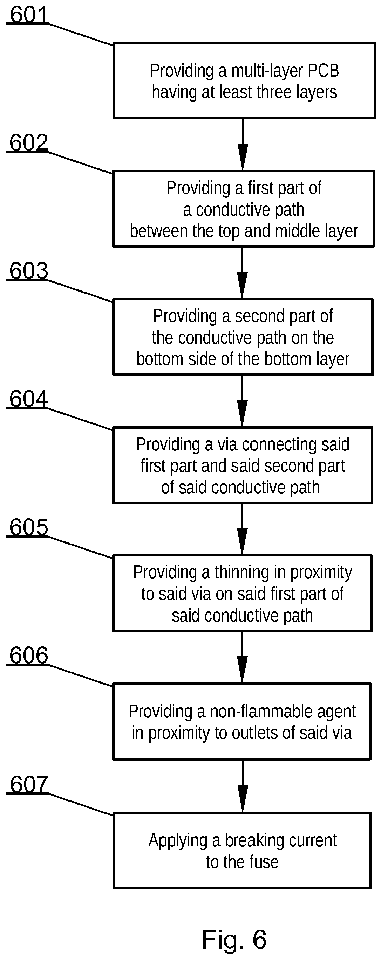

Fig. 6 shows a method according to the present invention. The aim of the presented method is to provide a multi-layer printed circuit board (100) comprising a high breaking capacity fuse according to the present invention. It may be considered a manufacturing method.

A first step (601) of the method is to provide a multi-layer PCB (100) having at least three layers (101a-d) to be assembled (namely: a first external layer (101a), a middle layer (101b) and a second external layer (101d)).

Subsequently, at step (602) of the method, there is provided a first part (102) (or otherwise section) of the conductive path (102, 103, 104, 105) between the top (101a) and the middle (101b) layer (preferably on an outer side of said middle layer (101b)).

Next, at step (603) there is provided a second part (105) of the conductive path (102, 103, 104, 105) on the bottom side of the bottom layer (101d). Further, at step (604) there is provided a via (104), passing via all layers (101a-d) as shown inn Fig. 1, connecting said first part (102) and said second part (105) (or otherwise section) of said conductive path (102, 103, 104, 105).

Subsequently, at step (605) there is provided a thinning (103) in proximity to said via (104) on said first part of said conductive path. The thinning (103) may be created when step (602) is executed, depending on the manufacturing process. Next, at step (606) there is provided a non-flammable agent (106) in proximity to outlets of said via (104) (as explained with reference to Fig. 1). In case there are more layers on top of the top layer (101a) and/or below the bottom layer (101d) the via (104) also passes these additional layers.

At this stage, the multi-layer printed circuit board (100) may be assembled as a final multi-layer printed circuit board (100) having a shape shown in Fig. 1. Optionally, there may be provided mounting holes, in the multi-layer printed circuit board (100), for receiving reinforcing members such as at least two soldered elements (108), in proximity to said non-flammable agent (106) located in proximity to the outlets of said via (104).

Lastly, in order to initiate said breaking, at step (607) there is applied a breaking current to the aforementioned fuse. In this case, the breaking current is 1500A at 240VAC (stands for Volts Alternating Current) in order to initiate said quenching of an electric arc.

Thus, the method for manufacturing the printed circuit board (100) comprising a high breaking capacity fuse, according to the present invention, is expanded to a method for quenching an electric arc, which comprises said manufacturing (step 601 - 606) and current application step resulting in required quenching.

While the invention presented herein has been depicted, described, and has been defined with reference to particular preferred embodiments, such references and examples of implementation in the foregoing specification do not imply any limitation on the invention. It will, however, be evident that various modifications and changes may be made thereto without departing from the broader scope of the technical concept. The presented preferred embodiments are exemplary only, and are not exhaustive of the scope of the technical concept presented herein.

Accordingly, the scope of protection is not limited to the preferred embodiments described in the specification, but is only limited by the claims that follow.

## Claims

1. High breaking capacity printed circuit fuse comprising:

   • a multi-layer printed circuit board (100) comprising: a first external layer (101a) present at a first side of a middle layer (101b) and a second external layer (101d) present opposite the first external layer (101a) with respect to the middle layer (101b);
   • a multi-layer circuit present on the multi-layer printed circuit board (100), the multi-layer circuit forming a conductive path (102, 103, 104, 105), which passes between said layers (101a-d);

   said high breaking capacity printed circuit fuse being **characterized in that**

   • said conductive path (102, 103, 104, 105) comprises:

      ○ a first end (102) located on the outer side of said middle layer (101b);
      ○ a thinning (103), at the level of the first end (102) of the conductive path (102, 103, 104, 105), which is configured to act as a fusible link;
      ○ a via (104) configured to pass, from said thinning (103) via all layers (101a-d), to the external side of the second external layer (101d);
      ○ a second end (105), connected at the end of said via (104), located on the external side of the second external layer (101d) of the multi-layer printed circuit board (100);

   • whereas a non-flammable agent (106) is present on the external side of at least the first external layer (101a), covering an outlet of said via (104) wherein the non-flammable agent (106) is such that the heat, caused by breaking the fuse will melt the non-flammable agent (106) and the melted non-flammable agent (106) will subsequently flood into the via (104).

2. The fuse according to claim 1 wherein there is at least one intermediate, internal layers (101c) between said middle layer (101b) and the second external layer (101d).

3. The fuse according to claim 1 wherein there is at least one layer above the first external layer (101a) and below the second external layer (101d).

4. The fuse according to claim 1 wherein the conductive path (102, 103, 104, 105) is made from a conductive foil.

5. The fuse according to claim 1 wherein the via (104) has its first end in proximity to said thinning (103).

6. The fuse according to claim 1 wherein the non-flammable agent (106) has properties allowing for electric arc quenching.

7. The fuse according to claim 1 wherein the non-flammable agent (106) is also present the external side of the second external layer (101a), covering the other outlet of said via (104).

8. The fuse according to claim 1 wherein the complete stack of the printed circuit board (100) is reinforced with reinforcing members (108) preventing delamination of the layers (101a-d).

9. The fuse according to claim 8 wherein the reinforcing members (108) are at least two soldered elements (108), in proximity to the non-flammable agent (106), positioned in mounting holes of the multi-layer printed circuit board (100).

10. The fuse according to claim 1 wherein the arrangement of the conductive path (102, 103, 104, 105) is mirrored with respect to an axis crossing the length of the middle layer (101b).

11. A method for providing a multi-layer printed circuit board (100) comprising a high breaking capacity fuse, the method comprising the steps of:

    • providing (601) a multi-layer printed circuit board (100) having at least three layers (101a-d) to be assembled: a first external layer (101a), a middle layer (101b) and a second external layer (101d);
    • providing (602) a first part (102) of the conductive path (102, 103, 104, 105) on an outer side of said middle layer (101b);
    • providing (603) a second part (105) of the conductive path (102, 103, 104, 105) on the external side of the second external layer (101d);

    the method being **characterized in that** it further comprises the step of:

    • providing (604) a via (104) connecting said first part (102) and said second part (105) of said conductive path (102, 103, 104, 105) and passing via all layers (101a-d);
    • providing (605) a thinning (103) in proximity to said via (104) on said first part (102) of said conductive path (102, 103, 104, 105);
    • providing (606) a non-flammable agent (106) on the external side of at least the first external layer (101a), covering an outlet of said via (104) wherein the non-flammable agent (106) is such that the heat, caused by breaking the fuse will melt the non-flammable agent (106) and the melted non-flammable agent (106) will subsequently flood into the via (104);
• assembling said multi-layer printed circuit board (100) comprising: a first external layer (101a) present at a first side of a middle layer (101b) and a second external layer (101d) present opposite the first external layer (101a) with respect to the middle layer (101b).

12. A method for quenching an electric arc, the method being **characterized in that** it comprises the steps of:

• providing a multi-layer printed circuit board (100) comprising a high breaking capacity fuse according to claim 1;
• applying (607) a breaking current to the high breaking capacity fuse.

**Patentansprüche**

1. Leiterplattensicherung mit hoher Ausschaltleistung, die Folgendes umfasst:

• eine mehrschichtige Leiterplatte (100), die Folgendes umfasst: eine erste Außenschicht (101a), die auf einer ersten Seite einer Mittelschicht (101b) liegt und eine zweite Außenschicht (101d), die in Bezug auf die Mittelschicht (101b) gegenüber der ersten Außenschicht (101a) liegt;
• eine mehrschichtige Schaltung, die auf der mehrschichtigen Leiterplatte (100) liegt, wobei die mehrschichtige Schaltung eine Leiterbahn (102, 103, 104, 105) bildet, die zwischen den Schichten (101a-d) hindurch läuft;

wobei die Leiterplattensicherung mit hoher Ausschaltleistung **dadurch gekennzeichnet ist, dass**

• die Leiterbahn (102, 103, 104, 105) Folgendes umfasst:
• ein erstes Ende (102), das sich an der Außenseite der Mittelschicht (101b) befindet;
• eine Ausdünnung (103) auf der Höhe des ersten Endes (102) der Leiterbahn (102, 103, 104, 105), die dazu konfiguriert ist, als schmelzbare Verbindung zu fungieren;
• ein Ableiter (104), der dazu konfiguriert ist, von der Ausdünnung (103) durch alle Schichten (101a-d) zu der Außenseite der zweiten Außenschicht (101d) zu leiten;
• ein zweites Ende (105), das am Ende mit dem Ableiter (104) verbunden und auf der Außenseite der zweiten Außenschicht (101d) der mehrschichtigen Leiterplatte (100) angebracht ist;
• wobei ein nicht flammbares Mittel (106) an der Außenseite von mindestens der ersten Außenschicht (101a) vorhanden ist und einen Auslass des Ableiters (104) bedeckt, wobei das nicht flammbare Mittel (106) derart ist, dass die Hitze durch das Unterbrechen der Sicherung das nicht flammbare Mittel (106) schmilzt und das geschmolzene nicht flammbare Mittel (106) anschließend in den Ableiter (104) fließt.

2. Sicherung nach Anspruch 1, wobei es mindestens eine innere Zwischenschicht (101c) zwischen der Mittelschicht (101b) und der zweiten Außenschicht (101d) gibt.

3. Sicherung nach Anspruch 1, wobei es mindestens eine Schicht über der ersten Außenschicht (101a) und unter der zweiten Außenschicht (101d) gibt.

4. Sicherung nach Anspruch 1, wobei die Leiterbahn (102, 103, 104, 105) aus Leiterfolie besteht.

5. Sicherung nach Anspruch 1, wobei das erste Ende des Ableiters (104) in der Nähe der Ausdünnung ist (103).

6. Sicherung nach Anspruch 1, wobei das nicht flammbare Mittel (106) Eigenschaften aufweist, die ein Löschen von elektrischen Lichtbögen ermöglichen.

7. Sicherung nach Anspruch 1, wobei das nicht flammbare Mittel (106) auch auf der Außenseite der zweiten Außenschicht (101a) vorhanden ist und den anderen Auslass des Ableiters (104) bedeckt.

8. Sicherung nach Anspruch 1, wobei der gesamte Stapel der Leiterplatte (100) mit Verstärkungselementen (108) verstärkt ist, die der Delaminierung der Schichten (101a-d) vorbeugen.

9. Sicherung nach Anspruch 8, wobei die Verstärkungselemente (108) aus mindestens zwei gelöteten Elementen (108) in der Nähe zu dem nicht flammbaren Mittel (106) bestehen und in Montageöffnungen der mehrschichtigen Leiterplatte (100) angeordnet sind.

10. Sicherung nach Anspruch 1, wobei die Anordnung der Leiterbahn (102, 103, 104, 105) in Bezug auf eine Achse, die die Länge der Mittelschicht (101b) kreuzt, gespiegelt ist.

11. Verfahren zur Herstellung einer mehrschichtigen Leiterplatte (100), die eine Sicherung mit hoher Ausschaltleistung umfasst, wobei das Verfahren die folgenden Schritte umfasst:

• Bereitstellen (601) einer mehrschichtigen Leiterplatte (100) mit mindestens drei Schichten (101a-d), die wie folgt zu verbinden sind: eine erste Außenschicht (101a), eine Mittelschicht (101b) und eine zweite Außenschicht (101d);
• Bereitstellen (602) eines ersten Teils (102) der Leiterbahn (102, 103, 104, 105) an einer Außenseite der Mittelschicht (101b);
• Bereitstellen (603) eines zweiten Teils (105) der Leiterbahn (102, 103, 104, 105) an der Außenseite der zweiten Außenschicht (101d);

wobei das Verfahren **dadurch gekennzeichnet ist, dass** es ferner die folgenden Schritte umfasst:

• Bereitstellen (604) eines Ableiters (104), der den ersten Teil (102) mit dem zweiten Teil (105) der Leiterbahn (102, 103, 104, 105) verbindet und durch alle Schichten (101a-d) führt;
• Bereitstellen (605) einer Ausdünnung (103) in der Nähe des Ableiters (104) an dem ersten Teil (102) der Leiterbahn (102, 103, 104, 105);
• Bereitstellen (606) eines nicht flammbaren Mittels (106) an der Außenseite von mindestens der ersten Außenschicht (101a), das einen Auslass des Ableiters (104) bedeckt, wobei das nicht flammbare Mittel (106) derart ist, dass die Hitze durch das Unterbrechen der Sicherung das nicht flammbare Mittel (106) schmilzt und das geschmolzene nicht flammbare Mittel (106) anschließend in den Ableiter (104) fließt;
• Zusammenbauen der mehrschichtigen Leiterplatte (100), die Folgendes umfasst:

eine erste Außenschicht (101a), die auf einer ersten Seite einer Mittelschicht (101b) liegt und
eine zweite Außenschicht (101d), die in Bezug auf die Mittelschicht (101b) gegenüber der ersten Außenschicht (101a) liegt.

12. Verfahren zum Löschen eines elektrischen Lichtbogens, wobei das Verfahren **dadurch gekennzeichnet ist, dass** es die folgenden Schritte umfasst:

• Bereitstellen einer mehrschichtigen Leiterplatte (100), die eine Sicherung mit hoher Ausschaltleistung nach Anspruch 1 umfasst;
• Anwenden (607) eines Ausschaltstroms auf die Sicherung mit hoher Ausschaltleistung.

**Revendications**

1. Fusible de circuit imprimé à haut pouvoir de coupure comprenant :

• une carte de circuit imprimé multicouche (100) comprenant : une première couche extérieure (101a) présente sur un premier côté d'une couche médiane (101b) et une seconde couche extérieure (101d) présente opposée à la première couche extérieure (101a) par rapport à la couche médiane (101b) ;
• un circuit multicouche présent sur la carte de circuit imprimé multicouche (100), le circuit multicouche formant un chemin conducteur (102, 103, 104, 105) qui passe entre lesdites couches (101 a à d) ;

ledit fusible de circuit imprimé à haut pouvoir de coupure étant **caractérisé en ce que**

• ledit chemin conducteur (102, 103, 104, 105) comprend :
• une première extrémité (102) située sur le côté extérieur de ladite couche médiane (101b) ;
• un amincissement (103), au niveau de la première extrémité (102) du chemin conducteur (102, 103, 104, 105), qui est conçu pour agir en tant que liaison fusible ;
• un via (104) conçu pour passer, à partir dudit amincissement (103) par toutes les couches (101a à d), jusqu'au côté extérieur de la seconde couche extérieure (101d) ;
• une seconde extrémité (105), connectée à l'extrémité dudit via (104), située sur le côté extérieur de la seconde couche extérieure (101d) de la carte de circuit imprimé multicouche (100) ;
• alors qu'un agent ininflammable (106) est présent sur le côté extérieur d'au moins la première couche extérieure (101a), recouvrant une sortie dudit via (104), ledit agent ininflammable (106) étant de sorte que la chaleur, provoquée par la rupture du fusible, fait fondre l'agent ininflammable (106) et l'agent ininflammable fondu (106) inondeensuite le via (104).

2. Fusible selon la revendication 1, au moins une couche interne intermédiaire (101c) entre ladite couche médiane (101b) et la seconde couche extérieure (101d).

3. Fusible selon la revendication 1, au moins une couche étant présente au-dessus de la première couche extérieure (101a) et au-dessous de la seconde couche extérieure (101d).

4. Fusible selon la revendication 1, ledit chemin conducteur (102, 103, 104, 105) étant fabriqué à partir d'une feuille conductrice.

5. Fusible selon la revendication 1, ledit via (104) possédant sa première extrémité à proximité dudit amincissement (103).

**6.** Fusible selon la revendication 1, ledit agent ininflammable (106) possédant des propriétés permettant l'extinction d'arc électrique.

**7.** Fusible selon la revendication 1, ledit agent ininflammable (106) étant également présent sur le côté extérieur de la seconde couche extérieure (101a), recouvrant l'autre sortie dudit via (104).

**8.** Fusible selon la revendication 1, ladite pile complète de la carte de circuit imprimé (100) étant renforcée par des éléments de renforcement (108) empêchant le délaminage des couches (101a à d).

**9.** Fusible selon la revendication 8, lesdites éléments de renforcement (108) étant au moins deux éléments soudés (108), à proximité de l'agent ininflammable (106), positionnés dans des trous de montage de la carte de circuit imprimé multicouche (100).

**10.** Fusible selon la revendication 1, ledit agencement du chemin conducteur (102, 103, 104, 105) étant symétrique par rapport à un axe traversant la longueur de la couche médiane (101b).

**11.** Procédé permettant de fournir une carte de circuit imprimé multicouche (100) comprenant un fusible à haut pouvoir de coupure, le procédé comprenant les étapes de :

> • fourniture (601) d'une carte de circuit imprimé multicouche (100) possédant au moins trois couches (101a à d) à assembler : une première couche extérieure (101a), une couche médiane (101b) et une seconde couche extérieure (101d) ;
> • fourniture (602) d'une première partie (102) du chemin conducteur (102, 103, 104, 105) sur un côté extérieur de ladite couche médiane (101b) ;
> • fourniture (603) d'une seconde partie (105) du chemin conducteur (102, 103, 104, 105) sur le côté extérieur de la seconde couche extérieure (101d) ;

le procédé étant **caractérisé en ce qu'**il comprend en outre les étapes de :

> • fourniture (604) d'un via (104) connectant ladite première partie (102) et ladite seconde partie (105) dudit chemin conducteur (102, 103, 104, 105) et passant par toutes les couches (101a à d) ;
> • fourniture (605) d'un amincissement (103) à proximité dudit via (104) sur ladite première partie (102) dudit chemin conducteur (102, 103, 104, 105) ;
> • fourniture (606) d'un agent ininflammable (106) du côté extérieur d'au moins la première couche extérieure (101a), recouvrant une sortie dudit via (104), ledit agent ininflammable (106) étant de sorte que la chaleur, provoquée par la rupture du fusible, fasse fondre l'agent ininflammable (106) et l'agent ininflammable fondu (106) noie ensuite le via (104) ;
• assemblage de ladite carte de circuit imprimé multicouche (100) comprenant : une première couche extérieure (101a) présente sur un premier côté d'une couche médiane (101b) et une seconde couche extérieure (101d) présente opposée à la première couche extérieure (101a) par rapport à la couche médiane (101b).

**12.** Procédé permettant d'éteindre un arc électrique, le procédé étant **caractérisé en ce qu'**il comprend les étapes de :

> • fourniture d'une carte de circuit imprimé multicouche (100) comprenant un fusible à haut pouvoir de coupure selon la revendication 1 ;
> • application (607) d'un courant de coupure au fusible à haut pouvoir de coupure.

Fig. 1

Fig. 2

<u>301</u>

Area of a path's cross-section vs time to break for a given current

Fig. 3

<u>401</u>

Joule's integral for a direct current
vs time

Fig. 4

Fig. 5

**601** Providing a multi-layer PCB having at least three layers

**602** Providing a first part of a conductive path between the top and middle layer

**603** Providing a second part of the conductive path on the bottom side of the bottom layer

**604** Providing a via connecting said first part and said second part of said conductive path

**605** Providing a thinning in proximity to said via on said first part of said conductive path

**606** Providing a non-flammable agent in proximity to outlets of said via

**607** Applying a breaking current to the fuse

Fig. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1045625 A1
- US 20120013431 A1

- JP 2007018774 A